# EUROPEAN PATENT APPLICATION

(11) **EP 1 873 830 A2**
(43) Date of publication of application: **02.01.2008**
(21) Application number: 07012605.7
(22) Date of filing: 27.06.2007
(51) Int. Cl.: H01L 25/16

(54) **Power amplifier module**

(30) Priority: 28.06.2006 JP 2006178100
(71) Applicant: NEC Electronics Corporation, Kawasaki, Kanagawa 211-8668 (JP)
(72) Inventor: Nishimura, Yoshikazu, Kawasaki, Kanagawa 211-8668 (JP); Goto, Keizo, Kawasaki, Kanagawa 211-8668 (JP)
(74) Representative: Glawe, Delfs, Moll

(57) **Abstract**

A power amplifier module (IC module) of stacked layer structure is miniaturized while dissipating heat from a power amplifier chip. The module includes a first LTCC wiring board having a cavity in which a power amplifier chip is embedded, and a plurality of vias, which are electrically connected to ground, immediately underlying the power amplifier chip; and a second LTCC wiring board joined to the first LTCC wiring board and incorporating a matching circuit and a bias circuit electrically connected to the power amplifier chip. Ground pads of the matching circuit and bias circuit are all grounded by separating wiring or vias in the first LTCC wiring board and second LTCC wiring board.

## Description

### RELATED APPLICATION

This application is based upon and claims the benefit of the priority of Japanese patent application No. 2006-178100, filed on June 28, 2006, the disclosure of which is incorporated herein in its entirety by reference thereto.

### FIELD OF THE INVENTION

This invention relates to an IC module having a plurality of wiring boards of a stacked structure, particularly, a power amplifier module those employing ceramic wiring boards, typically, LTCC (Low-Temperature Co-fired Ceramic) wiring boards. More particularly, the invention relates to a power amplifier module that enables miniaturization.

### BACKGROUND OF THE INVENTION

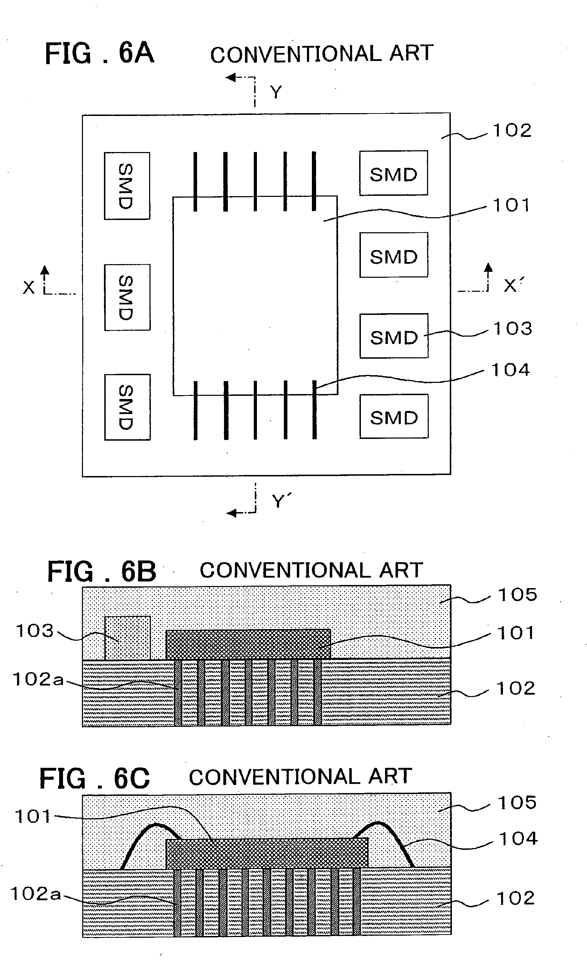

Power amplifier modules for WCDMA (Wideband Code Division Multiple Access) currently being developed typically have a size of 3 mm x 3 mm. As illustrated in Figs. 6A to 6C, a power amplifier module having a size of 3 mm x 3 mm comprises a power amplifier chip 101 constituted by a GaAsHBT (GaAs heterojunction bipolar transistor) or the like; an LTCC wiring board 102 having a stacked structure; SMDs (Surface Mount Devices) 103 such as capacitors or inductors; and Au wires 104 connecting the power amplifier chip 101 and the LTCC wiring board 102. A bias circuit having a suitable length and ground are provided within the LTCC wiring board 102. Further incorporated within the LTCC wiring board 102 if there is enough area is an input circuit. The power amplifier chip 101 on the LTCC wiring board 102 is mounted on the LTCC wiring board 102 via an electrically conductive bonding agent such as Ag paste and is electrically connected to the LTCC wiring board 102 by the Au wires 104. An input matching circuit, output matching circuit and bias circuit(s) constructed by combining seven or eight SMDs 103 such as capacitors and inductors are flip-chip mounted on the LTCC wiring board 102. Finally, the SMDs 103 and power amplifier chip 101 on the LTCC wiring board 102 are sealed by an insulating resin 105.

Further, in a power amplifier module disclosed heretofore, circuit elements that produce a large amount of heat are mounted on one surface of a circuit board, circuit elements that produce little heat are mounted on the other surface of the circuit board, and heat dissipating means is provided for dissipating the heat from the circuit elements that produce a large amount of heat (see Patent Document 1). In another disclosed example, at least one organic circuit board incorporating a semiconductor element such as an IC is stacked on one surface or on both surfaces of an LTCC board having passive elements and is integrated with the LTCC board (see Patent Document 2).

### [Patent Document 1]

Japanese Patent Kokai Publication No. JP-P2000-133765A

### [Patent Document 2]

Japanese Patent Kokai Publication No. JP-P2003-324181A

### SUMMARY OF THE DISCLOSURE

The following analyses are given by the present invention. The entire disclosure of Patent Documents 1 and 2 is incorporated herein by reference thereto.
A power amplifier module having a size of 3 mm x 3 mm is barely capable of being achieved with the conventional implementation. It is likely that there will be increasing demand for further miniaturization in the coming years and it is believed that meeting this demand will be difficult merely by an extension of conventional methods of manufacture. The reasons are set forth below.

In a case where miniaturization beyond the size of 3 mm x 3 mm is required in the future, it will be necessary to fabricate this as an IC (Integrated Circuit) by incorporating SMDs, which are presently mounted externally, in a power amplifier chip. However, since an output matching circuit, which has a major influence upon the characteristics of the power amplifier, requires a certain degree of line length, incorporating it in the power amplifier chip is difficult and therefore it is necessary to form the circuit externally.

In a case where an output matching circuit is formed externally of the power amplifier chip, the output matching circuit can be incorporated within the LTCC wiring board. The LTCC wiring board, however, uses up most of the area of the power amplifier chip. Consequently, the area immediately underlying the power amplifier chip within the LTCC wiring board is used to ground the power amplifier chip (see ground wiring 102a in Figs. 6B and 6C) from the standpoint of heat dissipation and grounding. This means that area available within the LTCC for fabricating the matching circuit is small.

Further, design rules exist that take how to assemble into consideration for the purpose of mounting SMDs, and there are prohibited areas along the edges. In a case where an LTCC wiring board is miniaturized, therefore, there is little possibility of a dramatic decrease in size of the power amplifier chip and, hence, the number of SMDs that can be mounted will decrease sharply.

With the module described in Patent Document 1, the board on which semiconductor chips and chip components have been mounted is covered by cover-shaped heat dissipating means. As a consequence, not only is there an increase in number of parts but a gap or gaps are also formed inside the heat dissipating means and it is difficult to miniaturize the module.

The module described in Patent Document 2 does not have a configuration that takes into consideration the heat dissipation and grounding of semiconductor elements incorporated within the organic circuit board. This module therefore is not suitable as a power amplifier module that evolves a great amount of heat.

It is an object of the present invention to miniaturize an IC module, particularly a power amplifier module while assuring the dissipation of heat therefrom.

According to a first aspect of the present invention, there is provided an IC module, particularly, a power amplifier module comprising: a first (e.g., low-temperature co-fired ceramic) wiring board having a cavity in which a power amplifier chip is embedded, and a plurality of vias, which are electrically connected to ground, immediately underlying the power amplifier chip; and a second (e.g., low-temperature co-fired ceramic) wiring board joined to the first low-temperature co-fired ceramic wiring board and incorporating one or both of a plurality of matching circuits and a plurality of bias circuits electrically connected to the power amplifier chip.

In a second aspect of the power amplifier module according to the present invention, the power amplifier chip and the first (low-temperature co-fired ceramic) wiring board may be electrically connected by bonding wiring within the cavity.

In a third aspect of the power amplifier module according to the present invention, the power amplifier chip and the first (low-temperature co-fired ceramic) wiring board may be electrically connected by bump jointing.

In a fourth aspect of the power amplifier module according to the present invention, the power amplifier chip may be provided with a via below a first pad for bonding purpose, a second pad corresponding to the via is provided on a reverse side of the power amplifier chip, and the power amplifier chip is bump-joined to the first low-temperature co-fired ceramic wiring board by the second pad. Typically, the first and second wiring boards are stacked together in registering each other.

The meritorious effects of the present invention are summarized as follows.
In accordance with the present invention, it is possible to realize a miniaturized IC module, e.g., power amplifier module that was difficult to achieve by an extension of the prior art.

Further, in accordance with the present invention (third to fourth aspects), cavity volume can be reduced and a bonding area is no longer necessary. This makes further miniaturization possible.

### BRIEF DESCRIPTION OF THE DRAWINGS

Fig. 1 is a block diagram schematically illustrating a power amplifier module according to a first example of the present invention;
Fig. 2 is a top view schematically illustrating the arrangement of a first LTCC wiring board in the power amplifier module according to the first example;
Fig. 3 is a bottom view schematically illustrating the arrangement of a second LTCC wiring board in the power amplifier module according to the first example;
Fig. 4 is a sectional view taken along line X-X' of Figs. 2 and 3 schematically illustrating the arrangement of the power amplifier module according to the first example;
Fig. 5 is a sectional view taken along line Y-Y' of Figs. 2 and 3 schematically illustrating the arrangement of the power amplifier module according to the first example; and
Figs. 6A, 6B and 6C are top view, a sectional view taken along line X-X' and a sectional view taken along line Y-Y', respectively, schematically illustrating the arrangement of a power amplifier module according to an example of the conventional art.

### PREFERRED MODES OF THE INVENTION

Preferred modes of the present invention will now be described in detail with reference to the drawings.

### (First Example)

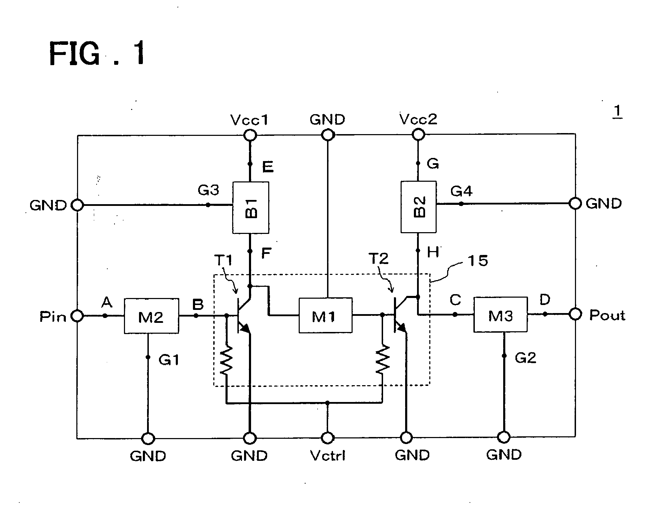

A power amplifier module according to a first example of the present invention will be described with reference to the drawings, in which Fig. 1 is a block diagram schematically illustrating a power amplifier module 1 according to the first example, exemplified as an IC module of a stacked structure.

The power amplifier module 1 depicted in Fig. 1 is indicative of a two-stage amplifier. The power amplifier module 1 has a power amplifier chip 15, an input matching circuit M2, an output matching circuit M3, a bias circuit B1 and a bias circuit B2.

The power amplifier chip 15 includes an interstage matching circuit M1 connected between an initial-stage transistor T1 and a final-stage transistor T2. The transistor T1 is constituted by a GaAsHBT or the like, e.g., and has a collector electrically connected to the interstage matching circuit M1 and to bias circuit B1, a base electrically connected to the input matching circuit M2 and electrically connected to a control pad Vctrl via a resistor, and an emitter electrically connected to a ground pad GND. The transistor T2 is constituted by a GaAsHBT or the like, e.g., and has a collector electrically connected to the output matching circuit M3 and to bias circuit B2, a base electrically connected to the interstage matching circuit M1 and electrically connected to the control pad Vctrl via a resistor, and an emitter electrically connected to a ground pad GND. The interstage matching circuit M1, which is a matching circuit for fully exploiting the output currents of the transistors T1 and T2, is obtained by combining inductors and capacitors, etc. The interstage matching circuit M1 has a first terminal electrically connected to the collector of transistor T1 and to bias circuit B1, a second terminal electrically connected to the base of transistor T2 and electrically connected to the control pad Vctrl via a resistor, and a third terminal electrically connected to a ground pad GND. It should be noted that although the interstage matching circuit M1 is implemented in a form in which it is incorporated within the power amplifier chip 15, it may be mounted externally. Further, although the resistors connected to the bases of the transistors T1 and T2, respectively, are implemented in a form in which they are incorporated within the power amplifier chip 15, these may be mounted externally.

The input matching circuit M2, which is a matching circuit mainly for performing impedance matching, is obtained by combining inductor and capacitor, etc. The input matching circuit M2 has a first terminal A electrically connected to an input pad Pin, a second terminal B electrically connected to the base of transistor T1, and a third terminal G1 electrically connected to a ground pad GND.

The output matching circuit M3, which is a matching circuit adapted to furnish a predetermined distortion level while outputting a required power, is obtained by combining inductor and capacitor, etc. The output matching circuit M3 has a first terminal C electrically connected to the base of transistor T2 and to the bias circuit B2, a second D terminal electrically connected to an output pad Pout, and a third terminal G2 electrically connected to a ground pad GND.

The bias circuit B1 is a circuit for supplying the collector of transistor T1 with power Vcc1 and has a first terminal F electrically connected to the collector of transistor T1 and to the interstage matching circuit M1, a second terminal E electrically connected to power pad Vcc1 and a third terminal G3 connected to a ground pad GND. The bias circuit B2 is a circuit for supplying the collector of transistor T2 with power Vcc2 and has a first terminal H electrically connected to the collector of transistor T2 and to the output matching circuit M3, a second terminal G electrically connected to power pad Vcc2 and a third terminal G4 connected to a ground pad GND. The bias circuits B1 and B2 ideally should have a wavelength that is one-fourth the wavelength of the frequency used. However, since such bias circuits usually will not fit in a small module, these bias circuit have a small length such as 1/16 wavelength, actually.

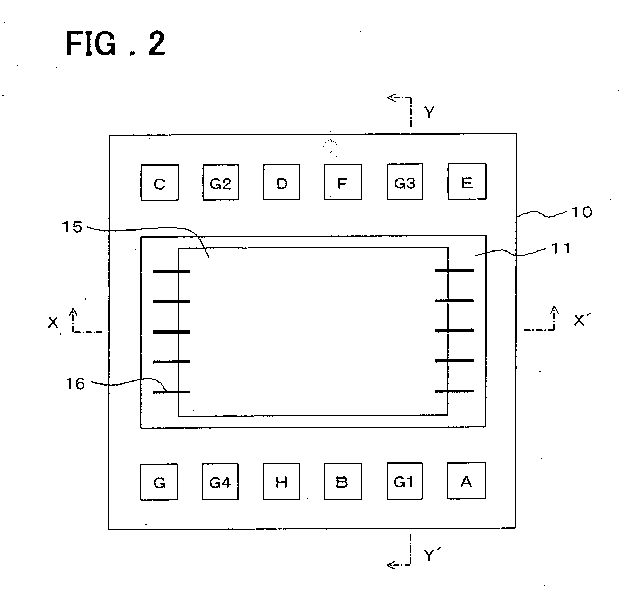

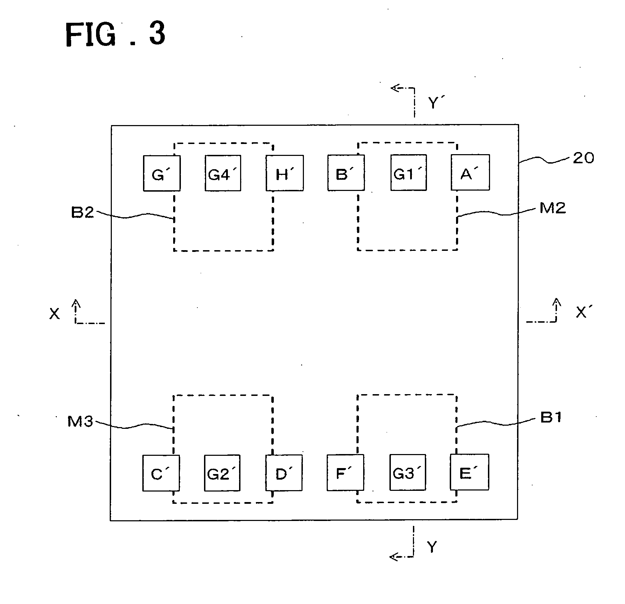

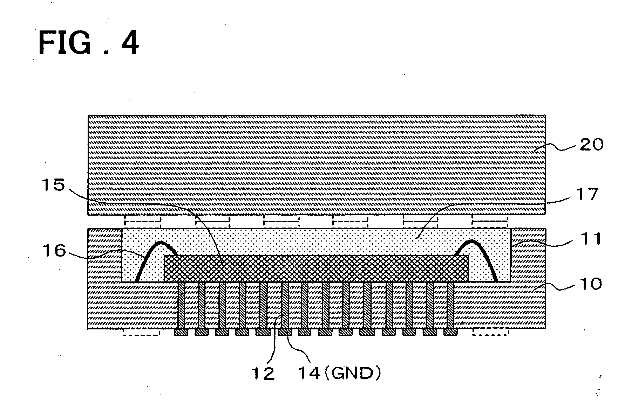

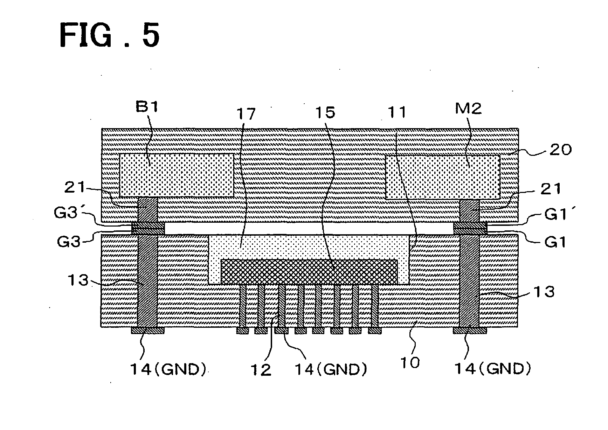

The circuit of the power amplifier module 1 described above is implemented in the structure set forth below according to the instant example. Fig. 2 is a top view schematically illustrating the arrangement of a first LTCC wiring board in the power amplifier module according to the first example of the present invention, Fig. 3 is a bottom view schematically illustrating the arrangement of a second LTCC wiring board in the power amplifier module according to the first example; Fig. 4 is a sectional view taken along line X-X' of Figs. 2 and 3 schematically illustrating the arrangement of the power amplifier module according to the first example, and Fig. 5 is a sectional view taken along line Y-Y' of Figs. 2 and 3 schematically illustrating the arrangement of the power amplifier module according to the first example.

The power amplifier module 1 is obtained by joining a first LTCC wiring board 10 having the power amplifier chip 15, and a second LTCC wiring board 20 having an input matching circuit and an output matching circuit.

The first LTCC wiring board 10 is a wiring board obtained by alternately stacking alternating layers of an insulating layer comprising a low-temperature co-firable ceramic composition and a wiring layer comprising a highly electrically conductive material such as copper, and electrically connecting the wiring layers by vias. The first LTCC wiring board 10 is provided with a cavity 11 on its top side at the central portion thereof in order to perform the role of a carrier on which the power amplifier chip 15 is placed. The power amplifier chip 15 is mounted in the cavity 11 via an electrically conductive bonding agent (not shown) such as Ag paste. The cavity 11 has such a depth that bonding wires 16 driven into (jointed to) the first LTCC wiring board 10 from the power amplifier chip 15 will not exceed the height of the first LTCC wiring board 10. The gap within the cavity 11 is sealed by an insulating resin 17.

A plurality of vias 12 for assuring dissipation of heat and improving the state of ground are disposed immediately below the power amplifier chip 15 within the first LTCC wiring board 10. For this reason it is difficult to incorporate a matching circuit, which comprises capacitor and inductor, etc., in the first LTCC wiring board 10. The vias 12 are electrically connected to ground pads 14 placed on the bottom side of the first LTCC wiring board 10 (see Figs. 4 and 5).

A plurality of pads A to G, G1 to G4 for being joined to the second LTCC wiring board 20 as by soldering are disposed along and in the periphery of the edges of the cavity 11 on the top surface of the first LTCC wiring board 10 (see Fig. 2). The symbols of the pads A to G, G1 to G4 correspond to the symbols in the block diagram of Fig. 1. Pad A is electrically connected through wiring (not shown) and a via (not shown) to the input pad Pin, which is placed on the bottom surface of the first LTCC wiring board 10, and is electrically connected to the input matching circuit M2 through a pad A' and wiring (not shown) and a via (not shown) in the second LTCC wiring board 20. Pad B is electrically connected to a corresponding pad (not shown) of power amplifier chip 15 through the bonding wire 16, wiring (not shown) and a via (not shown), and is electrically connected to the input matching circuit M2 through a pad B' and wiring (not shown) and a via (not shown) in the second LTCC wiring board 20. Pad C is electrically connected to a corresponding pad (not shown) of power amplifier chip 15 through the bonding wire 16, wiring (not shown) and a via (not shown), and is electrically connected to the output matching circuit M3 through a pad C' and wiring (not shown) and a via (not shown) in the second LTCC wiring board 20. Pad D is electrically connected through wiring (not shown) and a via (not shown) to the output pad Pout, which is placed on the bottom surface of the first LTCC wiring board 10, and is electrically connected to the output matching circuit M3 through a pad D' and wiring (not shown) and a via (not shown) in the second LTCC wiring board 20. Pad E is electrically connected through wiring (not shown) and a via (not shown) to the power pad Vcc1, which is placed on the bottom surface of the first LTCC wiring board 10, and is electrically connected to the bias circuit B1 through a pad E' and wiring (not shown) and a via (not shown) in the second LTCC wiring board 20. Pad F is electrically connected to a corresponding pad (not shown) of power amplifier chip 15 through the bonding wire 16, wiring (not shown) and a via (not shown), and is electrically connected to the bias circuit B1 through a pad F' and wiring (not shown) and a via (not shown) in the second LTCC wiring board 20. Pad G is electrically connected through wiring (not shown) and a via (not shown) to the power pad Vcc2, which is placed on the bottom surface of the first LTCC wiring board 10, and is electrically connected to the bias circuit B2 through a pad G' and wiring (not shown) and a via (not shown) in the second LTCC wiring board 20. Pad H is electrically connected to a corresponding pad (not shown) of power amplifier chip 15 through the bonding wire 16, wiring (not shown) and a via (not shown), and is electrically connected to the bias circuit B2 through a pad H' and wiring (not shown) and a via (not shown) in the second LTCC wiring board 20. Pad G1 is electrically connected through a via 13 to ground pad 14, which is placed on the bottom surface of the first LTCC wiring board 10, and is electrically connected to the input matching circuit M2 through a pad G1' and wiring (not shown) and a via 21 in the second LTCC wiring board 20 (see Fig. 5). Pad G2 is electrically connected through a via (not shown) to ground pad GND, which is placed on the bottom surface of the first LTCC wiring board 10, and is electrically connected to the output matching circuit M3 through wiring (not shown) and a via (not shown) in the second LTCC wiring board 20. Pad G3 is electrically connected through a via 13 to ground pad 14, which is placed on the bottom surface of the first LTCC wiring board 10, and is electrically connected to the bias circuit B1 through a pad G3' and wiring (not shown) and via 21 in the second LTCC wiring board 20 (see Fig. 5). Pad G4 is electrically connected through a via (not shown) to ground pad GND, which is placed on the bottom surface of the first LTCC wiring board 10, and is electrically connected to the bias circuit B2 through a pad G4' and wiring (not shown) and a via (not shown) in the second LTCC wiring board 20.

It should be noted that the degree of freedom of matching usually rises more if the circuitry of the output matching circuit M3 begins at a location as close as possible to the output of the transistor T2 in the power amplifier chip 15. Hence it is preferred that the output matching circuit M3 be placed at a position close to the output pad Pout. Further, in order that the input matching circuit M2 and output matching circuit M3 may prevent the power amplifier from oscillating, it is preferred that the ground pads GND of the respective matching circuits M2, M3 and bias circuits B1, B2 all be grounded by separate wiring and vias.

The first LTCC wiring board 10 has a via (not shown) electrically connected to a ground pad (not shown) of the power amplifier chip 15 via bonding wire 16, and a ground pad (not shown), which is provided on the bottom surface of the substrate, electrically connected to this via.

The second LTCC wiring board 20 is a wiring board obtained by alternately stacking alternating layers of an insulating layer comprising a low-temperature co-firable ceramic composition and a wiring layer comprising a highly electrically conductive material such as copper, and electrically connecting the wiring layers by vias. The input matching circuit M2, output matching circuit M3 and bias circuits B1, B2 are incorporated in the second LTCC wiring board 20. The second LTCC wiring board 20 can construct matching circuits if it has a stacked structure on the order of ten layers.

A plurality of pads A' to G', G1' to G4' for being joined to the first LTCC wiring board 10 as by soldering are disposed on the bottom surface of the second LTCC wiring board 20 (see Fig. 3). Pad A' is electrically connected to the input matching circuit M2 through wiring (not shown) and a via (not shown) in the second LTCC wiring board 20, and is electrically connected to the input pad Pin of the first LTCC wiring board 10 through a via (not shown) of first LTCC wiring board 10 and pad A. Pad B' is electrically connected to the input matching circuit M2 through wiring (not shown) and a via (not shown) in the second LTCC wiring board 20, and is electrically connected to the corresponding pad (not shown) of the first LTCC wiring board 10 via bonding wire 16, wiring (not shown) and a via (not shown) of the first LTCC wiring board 10 and pad B. Pad C' is electrically connected to the output matching circuit M3 through wiring (not shown) and a via (not shown) in the second LTCC wiring board 20, and is electrically connected to the corresponding pad (not shown) of the power amplifier chip 15 through bonding wire 16, wiring (not shown), a via (not shown) and pad C. Pad D' is electrically connected to the output matching circuit M3 through wiring (not shown) and a via (not shown) in the second LTCC wiring board 20, and is electrically connected to the input pad Pout of first LTCC wiring board 10 through a via (not shown) of first LTCC wiring board 10 and pad D. Pad E' is electrically connected to the bias circuit B1 through wiring (not shown) and a via (not shown) in the second LTCC wiring board 20, and is electrically connected to the power pad Vcc1 of first LTCC wiring board 10 through a via (not shown) of first LTCC wiring board 10 and pad E. Pad F' is electrically connected to the bias circuit B1 through wiring (not shown) and a via (not shown) in the second LTCC wiring board 20, and is electrically connected to the corresponding pad (not shown) of power amplifier chip 15 though bonding wire 16, wiring (not shown) and a via (not shown) of first LTCC wiring board 10 and pad F. Pad G' is electrically connected to the bias circuit B2 through wiring (not shown) and a via (not shown) in the second LTCC wiring board 20, and is electrically connected to the power pad Vcc2 of first LTCC wiring board 10 through a via (not shown) of first LTCC wiring board 10 and pad G. Pad H' is electrically connected to the bias circuit B2 through wiring (not shown) and a via (not shown) in the second LTCC wiring board 20, and is electrically connected to the corresponding pad (not shown) of first LTCC wiring board 10 via bonding wire 16, wiring (not shown) and a via (not shown) of first LTCC wiring board 10 and pad H. Pad G1' is electrically connected to the input matching circuit M2 through wiring (not shown) and via 21 in the second LTCC wiring board 20, and is electrically connected to ground pad 14 of first LTCC wiring board 10 through via 13 of first LTCC wiring board 10 and pad G1 (see Fig. 5). Pad G2' is electrically connected to the output matching circuit M3 through wiring (not shown) and a via (not shown) in the second LTCC wiring board 20, and is electrically connected to ground pad GND of first LTCC wiring board 10 through a via (not shown) of first LTCC wiring board 10 and pad G2. Pad G3' is electrically connected to the bias circuit B1 through wiring (not shown) and via 21 in the second LTCC wiring board 20, and is electrically connected to ground pad 14 of first LTCC wiring board 10 through via 13 of first LTCC wiring board 10 and pad G3 (see Fig. 5). Pad G4' is electrically connected to the bias circuit B2 through wiring (not shown) and a via (not shown) in the second LTCC wiring board 20, and is electrically connected to ground pad GND of first LTCC wiring board 10 through a via (not shown) of first LTCC wiring board 10 and pad G4.

It should be noted that bypass capacitors having a capacitance of, e.g., 1000 pF, usually are provided at the leading ends of the bias circuits B1, B2. However, depending upon the size of the second LTCC wiring board 20, there are cases where it is difficult to incorporate a large capacitance of 1000 pF. In such cases, therefore, the bypass capacitors may be mounted externally. Since techniques that will enable the incorporation of large-capacitance capacitors are now be developed, however, it may be possible to incorporate such capacitor(s) in the future.

In accordance with the first example, it is possible to realize a miniaturized power amplifier module that was difficult to achieve by an extension of the prior art.

(Second Example)

A power amplifier module according to a second example of the present invention will now be described. In the power amplifier module according to the second example, the connection between the first LTCC wiring board and the power amplifier chip uses bump-joining instead of bonding wire. As a result, the volume of the cavity can be reduced, a bonding area is no longer necessary and further miniaturization can be achieved.

(Third Example)

A power amplifier module according to a third example of the present invention will now be described. In the power amplifier module according to the third example, the power amplifier chip is made one in which a via is provided below the bonding pad and a pad corresponding to this via is provided on the reverse side (underside) of the chip. The power amplifier chip is bump-joined to the first LTCC wiring board. As a result, the volume of the cavity can be reduced, a bonding area is no longer necessary and further miniaturization can be achieved.
As many apparently widely different modes or examples of the present invention can be made without departing from the spirit and scope thereof, it is to be understood that the invention is not limited to the specific examples thereof except as defined in the appended claims.

In a further aspect, the IC module of a stacked layer structure comprises a first wiring board and a second wiring board wiring board, each of which may be a co-fired ceramic wiring board of the stacked layer structure, typically, fired at low-temperature. More particularly, there is provided an IC module comprising: a first wiring board and a second wiring board in a stacked structure, the first wiring board having a cavity in which a heat evolving chip is embedded, and a plurality of vias, which are electrically connected to ground, immediately underlying the heat evolving chip; and the second wiring board being stackedly joined to the first wiring board and incorporating one or both of a plurality of matching circuits and a plurality of bias circuits electrically connected to the heat evolving chip.

## Claims

1. A power amplifier module comprising:
a first low-temperature co-fired ceramic wiring board having a cavity in which a power amplifier chip is embedded, and a plurality of vias, which are electrically connected to ground, immediately underlying the power amplifier chip; and
a second low-temperature co-fired ceramic wiring board joined to said first low-temperature co-fired ceramic wiring board and incorporating one or both of a plurality of matching circuits and a plurality of bias circuits electrically connected to the power amplifier chip.

2. The power amplifier module according to claim 1, wherein the power amplifier chip and said first low-temperature co-fired ceramic wiring board are electrically connected by bonding wiring within the cavity.

3. The power amplifier module according to claim 1, wherein the power amplifier chip and said first low-temperature co-fired ceramic wiring board are electrically connected by bump jointing.

4. The power amplifier module according to claim 1, wherein the power amplifier chip is provided with a via below a first pad for bonding purposes, a second pad corresponding to the via is provided on a reverse side of the power amplifier chip, and the power amplifier chip is bump-joined to said first low-temperature co-fired ceramic wiring board by the second pad.

5. The power amplifier module according to any one of claims 1 to 4, wherein ground pads of one or both of the plurality of matching circuits and plurality of bias circuits are all grounded by separate wiring or vias in said first low-temperature co-fired ceramic wiring board and said second low-temperature co-fired ceramic wiring board.

6. The power amplifier module according to any one of claims 1 to 6, wherein said first and second low-temperature co-fired ceramic wiring boards are stacked together in registering each other.

7. An IC module comprising:
a first wiring board and a second wiring board in a stacked structure,
said first wiring board having a cavity in which a heat evolving chip is embedded, and a plurality of vias, which are electrically connected to ground, immediately underlying the heat evolving chip; and
said second wiring board being stackedly joined to said first wiring board and incorporating one or both of a plurality of matching circuits and a plurality of bias circuits electrically connected to the heat evolving chip.

8. The IC module according to claim 7, wherein the heat evolving chip and said first wiring board are electrically connected by bonding wiring within the cavity.

9. The IC module according to claim 7, wherein the heat evolving chip and said first wiring board are electrically connected by bump jointing.

10. The IC module according to claim 7, wherein the heat evolving chip is provided with a via below a first pad for bonding purposes, a second pad corresponding to the via is provided on a reverse side of the heat evolving chip, and the heat evolving chip is bump-joined to said first wiring board by the second pad.

11. The IC module according to any one of claims 7 to 10, wherein ground pads of one or both of the plurality of matching circuits and plurality of bias circuits are all grounded by separate wiring or vias in said first wiring board and said second wiring board.

12. The IC module according to any one of claims 7 to 11, wherein said first and second wiring boards are stacked together in registering each other.

13. The IC module according to any one of claims 7 to 12, wherein each of said first and second wiring boards is a co-fired ceramic board of a stacked layer structure.

14. The IC module according to claim 13, wherein each of said first and second wiring boards is a low temperature co-fired ceramic wiring board.

15. The IC module according to any one of claims 7 to 14, wherein said heat evolving chip comprises a power amplifier chip.
